(19) Europäisches Patentamt
European Patent Office
Office européen des brevets

(11) Veröffentlichungsnummer: **0 510 567 A2**

(12) **EUROPÄISCHE PATENTANMELDUNG**

(21) Anmeldenummer: **92106759.1**

(22) Anmeldetag: **21.04.92**

(51) Int. Cl.5: **C23C 16/34**, C07F 5/02, C23C 16/50, C23C 14/06

(30) Priorität: **26.04.91 DE 4113791**

(43) Veröffentlichungstag der Anmeldung: **28.10.92 Patentblatt 92/44**

(84) Benannte Vertragsstaaten: **AT BE CH DE DK ES FR GB IT LI NL SE**

(71) Anmelder: **Solvay Deutschland GmbH**
**Hans-Böckler-Allee 20, Postfach 2 20**
**W-3000 Hannover 1(DE)**
Anmelder: **FRAUNHOFER-GESELLSCHAFT ZUR FÖRDERUNG DER ANGEWANDTEN FORSCHUNG E.V.**
**Leonrodstrasse 54**
**W-8000 München 19(DE)**

(72) Erfinder: **Döllein, Günther**
**Meitnerstrasse 7**
**W-3000 Hannover 61(DE)**
Erfinder: **Weidenbach, Günter**
**Lehrter Strasse 52**
**W-3000 Hannover 71(DE)**
Erfinder: **Meyer, Hans**
**Fritz-Reuter-Strasse 12**
**W-3050 Wunstorf 1(DE)**
Erfinder: **Bringmann, Udo**
**Schulstrasse 18**
**W-2083 Halstenbek(DE)**
Erfinder: **Weber, Andreas**
**Woldsenweg 2**
**W-2000 Hamburg 20(DE)**
Erfinder: **Klages, Claus-Peter**
**Kanalstrasse 18**
**W-2000 Hamburg 76(DE)**

(74) Vertreter: **Lauer, Dieter, Dr.**
**c/o Kali-Chemie AG Postfach 220**
**Hans-Böckler-Allee 20**
**W-3000 Hannover 1(DE)**

(54) **Verfahren zur Abscheidung einer Bor und Stickstoff enthaltenden Schicht.**

(57) Beschrieben wird ein Verfahren zur Abscheidung B und N enthaltender Schichten mit N-substituierten Borazolen, insbesondere nach einem Plasma-CVD-Verfahren.

EP 0 510 567 A2

Die Erfindung bezieht sich auf ein Verfahren zur Abscheidung einer Bor (B) und Stickstoff (N) enthaltenden Schicht auf einem Substrat.

Es ist bekannt, Substrate durch Oberflächenbeschichtung gegenüber äußeren Einflüssen, beispielsweise Oxidation oder mechanische Beanspruchung, zu schützen. Es ist ferner bereits bekannt, zur Abscheidung von Bor und Stickstoff enthaltenden Schichten Diboran oder Borhalogenid in Anwesenheit von Ammoniak zu zersetzen. Diboran bzw. Borhalogenide sind jedoch gefährliche, schwierig zu handhabende Substanzen.

Aufgabe der vorliegenden Erfindung ist es, ein Verfahren zur Abscheidung einer Bor (B) und Stickstoff (N) enthaltenden Schicht anzugeben, welches die Nachteile der bekannten Verfahren nicht aufweist. Diese Aufgabe wird durch das erfindungsgemäße Verfahren gelöst.

Das erfindungsgemäße Verfahren zur Abscheidung einer Bor (B) und Stickstoff (N) enthaltenden Schicht auf einem Substrat ist dadurch gekennzeichnet, daß man durch Zersetzung einer Verbindung der allgemeinen Formel (I), (II) oder (III)

(siehe Formeln I, II und III)

worin $R^1$, $R^2$ und $R^3$ gleich oder verschieden sein können und bedeuten:
lineares oder verzweigtes Alkyl mit 1 bis 12 C-Atomen;
lineares oder verzweigtes Alkyl, substituiert durch ein oder mehrere Substituenten ausgewählt aus Halogen, Niedrigalkyloxy, Diniedrigalkylamin und dessen Adukt mit $BH_3$;
lineares oder verzweigtes Alkyl, substituiert durch ein oder mehrere Aryl-Reste, insbesondere Phenyl;
lineares oder verzweigtes Alkyl, substituiert durch ein oder mehrere Aryl-Reste, die ihrerseits durch ein oder mehrere Substituenten ausgewählt aus der Gruppe Halogen, Niedrigalkyl, halogeniertes Niedrigalkyl substituiert sind;
Cycloalkyl, Cycloalkenyl oder Cycloalkadienyl mit einem C4-C7-Kohlenstoffring;
Cycloalkyl, Cycloalkenyl oder Cycloalkadienyl mit einem C4-C7-Kohlenstoffring, substituiert durch Niedrigalkyl;
Aryl, insbesondere Phenyl, Toluyl, Aryl mit einem oder mehreren kondensierten Ringen, insbesondere Naphthyl;
Aryl, insbesondere Phenyl, substituiert durch einen oder mehrere Substituenten ausgewählt aus der Gruppe Halogen, Niedrigalkyl; durch Halogen substituiertes Niedrigalkyl; Niedrigalkoxy; Diniedrigalkylamin; Phenyl; Cycloalkyl mit C4-C7-Kohlenstoffring;
Alkenyl mit 2 bis 4 C-Atomen;
Triniedrigalkylsilyl;
Halogen, vorzugsweise Fluor
eine B und N enthaltende Schicht abscheidet.
Niedrigalkyl ist C1-C3-Alkyl.

$R^1$, $R^2$ und $R^3$ können beispielsweise bedeuten:
Me, Et, n-Pr, i-Pr, n-Bu, i-Bu, s-Bu, t-Bu, $CH_2$-$CF_3$, $CH_2$-$CH_2$-Cl, $CH_2$-$CCl_3$, $CH_2$-$CH_2$-Br, $CH_2$-CH=$CH_2$, $(CH_2)_2$-$CH_2$-Cl, $(CH_2)_2$-$CH_2$-$OCH_3$, $(CH_2)_2$-$CH_2$-$NMe_2$, $(CH_2)_2$-$CH_2$-$NMe_2$•$BH_3$;
Phenyl, $C_6F_5$, $C_6H_4$-2-Cl, $C_6H_4$-3-Cl, $C_6H_4$-4-Cl, $C_6H_4$-3-Br, $C_6H_4$-4-Br, $C_6H_4$-2-Me, $C_6H_4$-3-Me, $C_6H_4$-4-Me, $C_6H_4$-2-$CF_3$, $C_6H_4$-4-OMe, $C_6H_4$-2-Et, $C_6H_4$-4-Et; $C_6H_4$-4-$NMe_2$; $C_6H_4$-2-Ph, $C_6H_4$-4-cyclo$C_6H_{11}$;
$C_6H_3$-2-Cl-6-F, $C_6H_3$-3,5-$Cl_2$, $C_6H_3$-2,6-$Cl_2$, $C_6H_3$-2Cl-5-$CF_3$, $C_6H_3$-3,5-$(CF_3)_2$, $C_6H_3$-2-Me-4-cyclo$C_6H_{11}$;
$C_6H_2$-3,4,6-$Cl_3$;
$CH_2$-$C_6H_5$, $CH_2$-$C_6F_5$, $CH_2$-$C_6H_4$-2-Cl;
cyclo$C_6H_{11}$;
n-$C_{12}H_{25}$;
$CH(C_6H_5)_2$;
1-$C_{10}H_7$ (=Naphthyl);
$SiMe_3$;
Fluor.

Für den Fachmann ist klar, daß z.B. "$C_6H_4$-2-Cl" für in ortho-Stellung durch Chlor substituiertes Phenyl steht und daß Me für Methyl, Pr für Propyl, Bu für Butyl steht.
Halogenfreie Verbindungen sind bevorzugt.

In Verbindungen der allgemeinen Formel (II) bedeutet $R^1$ bzw. $R^2$ vorzugsweise Methyl, Ethyl, n-Propyl, i-Propyl, i-Butyl, s-Butyl, oder $CH_2$-n-$C_3F_7$. Gut geeignet sind Verbindungen, in denen $R^1$ und $R^2$ gleich sind, also z.B. N,N'-Dimethylborazol; N,N'-Diethylborazol; N,N'-Di-n-propylborazol; N,N'-Di-i-propylborazol; N,N'-Di-i-butylborazol; N,N'-Di-s-butylborazol und N,N'-Di-(n-Trifluorpropylmethyl)borazol. Verbindungen, in denen $R^1$ und $R^2$ nicht gleich sind, können aber auch verwendet werden.

Als Verbindungen der allgemeinen Formel (III) verwendet man vorzugsweise N-Methylborazol, N-Ethylborazol, N-n-Propylborazol, N-i-Propylborazol, N-i-Butylborazol, N-s-Butylborazol oder N-t-Butylborazol.

Im Verfahren der vorliegenden Erfindung verwendet man bevorzugt eine Verbindung der allgemeinen Formel (I). In der verwendeten Verbindung der allgemeinen Formel (I) können die Substituenten $R^1$, $R^2$ und $R^3$ gleich oder verschieden sein.

Einsetzbar sind beispielsweise die N,N',N''-substituierten Borazole

$(Me)_3B_3N_3$, $(Et)_3B_3N_3$, $(n\text{-}Pr)_3B_3N_3$, $(i\text{-}Pr)_3B_3N_3$, $(n\text{-}Bu)_3B_3N_3$, $(i\text{-}Bu)_3B_3N_3$, $(s\text{-}Bu)_3B_3N_3$, $(t\text{-}Bu)_3B_3N_3$, $(CH_2\text{-}CF_3)_3B_3N_3$, $(CH_2\text{-}CH_2\text{-}Cl)_3B_3N_3$, $(CH_2\text{-}CCl_3)_3B_3N_3$,$(CH_2\text{-}CH_2\text{-}Br)_3B_3N_3$, $(CH_2\text{-}CH=CH_2)_3B_3N_3$,$((CH_2)_2\text{-}CH_2\text{-}Cl)_3B_3N_3$, $((CH_2)_2\text{-}CH_2\text{-}OCH_3)_3B_3N_3$, $((CH_2)_2\text{-}CH_2\text{-}NMe_2)_3B_3N_3$, $((CH_2)_2\text{-}CH_2\text{-}NMe_2 \bullet BH_3)_3B_3N_3$;

$(Phenyl)_3B_3N_3$, $(C_6F_5)_3B_3N_3$, $(C_6H_4\text{-}2\text{-}Cl)_3B_3N_3$, $(C_6H_4\text{-}3\text{-}Cl)_3B_3N_3$, $(C_6H_4\text{-}4\text{-}Cl)_3B_3N_3$, $(C_6H_4\text{-}3\text{-}Br)_3B_3N_3$,$(C_6H_4\text{-}4\text{-}Br)_3B_3N_3$, $(C_6H_4\text{-}2\text{-}Me)_3B_3N_3$, $(C_6H_4\text{-}3\text{-}Me)_3B_3N_3$,$(C_6H_4\text{-}4\text{-}Me)_3B_3N_3$, $(C_6H_4\text{-}2\text{-}CF_3)_3B_3N_3$, $(C_6H_4\text{-}4\text{-}OMe)_3B_3N_3$, $(C_6H_4\text{-}2\text{-}Et)_3B_3N_3$, $(C_6H_4\text{-}4\text{-}Et)_3B_3N_3$; $(C_6H_4\text{-}4\text{-}NMe_2)_3B_3N_3$; $(C_6H_4\text{-}2\text{-}Ph)_3B_3N_3$, $(C_6H_4\text{-}4\text{-}cycloC_6H_{11})_3B_3N_3$; $(C_6H_3\text{-}2\text{-}Cl\text{-}6\text{-}F)_3B_3N_3$, $(C_6H_3\text{-}3{,}5\text{-}Cl_2)_3B_3N_3$, $(C_6H_3\text{-}2{,}6\text{-}Cl_2)_3B_3N_3$, $(C_6H_3\text{-}2\text{-}Cl\text{-}5\text{-}CF_3)_3B_3N_3$, $(C_6H_3\text{-}3{,}5\text{-}(CF_3)_2)_3B_3N_3$, $(C_6H_3\text{-}2\text{-}Me\text{-}4\text{-}cycloC_6H_{11})_3B_3N_3$;

$(C_6H_2\text{-}3{,}4{,}6\text{-}Cl_3)_3B_3N_3$;

$(CH_2\text{-}C_6H_5)_3B_3N_3$, $(CH_2\text{-}C_6F_5)_3B_3N_3$, $(CH_2\text{-}C_6H_4\text{-}2\text{-}Cl)_3B_3N_3$;

$(cycloC_6H_{11})_3B_3N_3$;

$(n\text{-}C_{12}H_{25})_3B_3N_3$;

$(CH(C_6H_5)_2)_3B_3N_3$;

$(1\text{-}C_{10}H_7)_3B_3N_3$;

$(SiMe_3)_3B_3N_3$;

$F_3B_3N_3$.

Borazole, in denen $R^1$, $R^2$ und $R^3$ nicht gleich sind, können ebenfalls eingesetzt werden.

Besonders bevorzugt verwendet man eine Verbindung, insbesondere eine Verbindung der allgemeinen Formel (I), in welcher $R^1$, $R^2$ und/oder $R^3$ gleich oder verschieden sein können und lineares oder verzweigtes Alkyl mit 1 bis 12 C-Atomen, vorzugsweise lineares oder verzweigtes Alkyl mit 1 bis 5 C-Atomen, insbesondere Methyl, Ethyl, n-Propyl, i-Propyl, n-Butyl, i-Butyl oder t-Butyl bedeutet.

Unter jenen Verbindungen, in welchen $R^1$, $R^2$ und $R^3$ nicht die gleiche Bedeutung aufweisen, sind diejenigen Verbindungen besonders gut geeignet, in welchen $R^1$ und $R^2$ die gleiche Bedeutung und $R^3$ eine andere Bedeutung besitzen. Die Substituentenpaarungen einiger Verbindungen dieser Art sind in der folgenden Tabelle aufgelistet.

| $R^1$,$R^2$ | Me | Me | Et | Me | i-Pr | Me | Et | Et | i-Pr | t-Bu | t-Bu $C_6H_{11}$ | t-Bu | Cyclo-$C_6H_{11}$ | H | F |
|---|---|---|---|---|---|---|---|---|---|---|---|---|---|---|---|
| $R^3$ | Et | i-Pr | i-Pr | t-Bu | t-Bu | Cyclo-$C_6H_{11}$ | Cyclo-$C_6H_{11}$ | Me | Me | Et | Me | i-Pr | Me | F | H |

Für den Fachmann ist klar, daß diese Tabelle konkrete Verbindungen nennt. Die in der ersten Spalte dieser Tabelle wiedergegebene Verbindung ist z.B. N,N'-Dimethyl-N''-ethylborazol.

Ganz besonders bevorzugt verwendet man eine Verbindung der allgemeinen Formel (I), in welcher $R^1$, $R^2$ und $R^3$ gleich sind. Hervorragend geeignet sind folgende Verbindungen der allgemeinen Formel (I): N,N',N''-Trimethylborazol, N,N',N''-Triethylborazol, N,N',N''-Tri-n-propylborazol, N,N',N''-Tri-i-Propylborazol, N,N',N''-Tri-n-Butylborazol, N,N',N''-Tri-i-Butylborazol oder N,N',N''-Tri-t-Butylborazol. Besonders bevorzugt sind N,N',N''-Trimethylborazol oder N,N',N''-Triethylborazol.

Die Herstellung von Verbindungen der allgemeinen Formel (I), (II) bzw. (III) ist bekannt , z.B. aus J. Bonham, R.S. Drago, Inorg. Synth. 9 (1967), Seiten 8 bis 12, sowie der DE-PS 11 56 071.

Zur Herstellung von Borazolen aus unter Normalbedingungen gasförmig vorliegenden Aminen setzt man Natriumborhydrid und ein entsprechendes Alkylammoniumchlorid in einem hochsiedenden Lösungsmittel um. Methylammoniumchlorid beispielsweise reagiert gemäß der folgenden Gleichung:

$$3NaBH_4 + 3CH_3\text{-}NH_3Cl \rightarrow (CH_3\text{-}N\text{-}B\text{-}H)_3 + 3NaCl + 9H_2 \quad (1)$$

Diese Herstellungsmethode weist den Vorteil auf, daß eine feste Stickstoffverbindung verwendet werden kann.

Zur Synthese von Borazolen aus flüssigen Aminen eignet sich auch die Umsetzung von Natriumborhydrid und Bortrifluorid-Etherat in einem Ether, beispielsweise Tetrahydrofuran nach der folgenden allgemeinen Reaktionsgleichung:

$$12R\text{-}NH_2 + 9NaBH_4 + 12BF_3 \bullet O(C_2H_5)_2 \rightarrow 4(R\text{-}N\text{-}B\text{-}H)_3 + 9NaBF_4 + 12(C_2H_5)_2O + 24H_2 \quad (2)$$

Die synthetisierten Borazole werden dann durch Destillation oder Sublimation gereinigt.

Zur Herstellung von Borazolen, in welchen $R^1$, $R^2$ bzw. $R^3$ nicht gleich sind bzw. in welchen $R^2$ und/oder $R^3$ Wasserstoff bedeuten, kann man beispielsweise Diboran, $NH_3$ und ein primäres Amin bei hoher Temperatur (bei Methylamin z.B. 200 °C) ca. 15 bis 30 Minuten miteinander umsetzen. Die sich bildenden drei Borazole werden durch fraktionierte Kondensation getrennt.

Die Abscheidung der B und N enthaltenden Schicht erfolgt bevorzugt aus der Gasphase. Der Begriff "Gasphase" schließt nicht aus, daß gegebenenfalls Flüssigkeitströpfchen ebenfalls in der Gasatmosphäre vorhanden sein können. Mit anderen Worten, der Begriff "Gasphase" umschließt auch den Begriff "Dampfphase".

Die Abscheidung kann aber auch aus der kondensierten Phase erfolgen.

Für den Fachmann ist selbstverständlich, daß er nicht nur eine bestimmte Verbindung der allgemeinen Formel (I), (II) oder (III) verwenden kann. Es können natürlich auch Gemische solcher Verbindungen verwendet werden, beispielsweise Gemische zweier oder mehr Verbindungen der allgemeinen Formel (I), Gemische zweier oder mehr Verbindungen der allgemeinen Formel (I) und (II) etc. Wenn im Folgenden davon die Rede ist, "eine Verbindung" anzuwenden, so gilt analoges auch für ein Gemisch von Verbindungen.

Zur Abscheidung aus der kondensierten Phase bringt der Fachmann die Borazolausgangsverbindung ohne Lösungsmittel oder beispielsweise in einem Lösungsmittel gelöst auf dem Substrat auf und zersetzt die Verbindung. Geeignete Lösungsmittel sind beispielsweise polare oder unpolare, aprotische organische Lösungsmittel.

Um die jeweilige Ausgangsverbindung auf dem Substrat aufzubringen, kann man sich bekannter Methoden bedienen. Beispielsweise kann man das Substrat in die Verbindung oder eine entsprechende Lösung dieser Verbindung eintauchen, man kann die Ausgangsverbindung oder eine entsprechende Lösung auf dem Substrat aufstreichen oder, bevorzugt, die Verbindung oder eine entsprechende Lösung auf das Substrat aufsprühen.

Mittels dieser Ausführungsform gelingt es, auch große Flächen sehr schnell zu beschichten.

Dann erfolgt die Zersetzung der auf dem Substrat aufgebrachten Ausgangsverbindung zur Abscheidung einer B und N enthaltenden Schicht. Dies kann gewünschtenfalls unter vermindertem Druck geschehen. Zweckmäßig bewirkt man die Zersetzung thermisch.

Dies kann durch Einbringen des mit der Ausgangsverbindung versehenen Substrats in eine entsprechend beheizte Kammer, durch Heizen des Substrats vor, während und/oder nach dem Aufbringen der Ausgangsverbindung auf eine genügend hohe Temperatur erfolgen.

Die thermische Zersetzung kann auch strahlungsinduziert bewirkt werden, beispielsweise durch einen Laser, der im UV-Bereich, im Infrarot-Bereich oder im Bereich des sichtbaren Lichts arbeitet.

Gewünschtenfalls kann die Zersetzung auch durch Photolyse erfolgen. Die photolytische Zersetzung kann durch einen bei der entsprechenden Wellenlänge betriebenen Laser oder eine UV-Lampe bewirkt werden.

Die Zersetzung kann man auch plasmainduziert durchführen. Dies kann nach einer der bekannten Plasma-Methoden durchgeführt werden, beispielsweise durch ein Niederdruckplasma, z.B. Gleichstrom- oder Wechselstromplasma oder durch ein Glimmentladungsplasma, ferner durch ein thermisches Plasma. Plasmareaktoren, die verwendet werden können sind dem Fachmann bekannt.

Der Fachmann kann durch Zusatz weiterer Gase die Form, in welcher B und N enthaltende Schichten abgeschieden werden, beeinflussen. Dies, sowie die Möglichkeit der gleichzeitigen oder sukzessiven Abscheidung anderer Metalle wird noch erläutert.

Die andere Ausführungsform betrifft die Zersetzung der Ausgangsverbindung in der Gasphase. Diese Ausführungsform ist bevorzugt und ermöglicht die Abscheidung besonders gut haftender, gleichmäßiger, dünner und gegebenenfalls transparenter Schichten.

Insbesondere bei dieser Ausführungsform verwendet man Verbindungen, vorzugsweise Verbindungen der allgemeinen Formel (I), die bei einer Temperatur von maximal 150 °C und Normaldruck oder vorzugsweise vermindertem Druck in die Gasphase überführbar sind. Beispielsweise weisen Verbindungen, in welchem $R^1$, $R^2$ und/oder $R^3$ Me, Et, n-Pr, i-Pr, n-Bu, i-Bu, s-Bu, t-Bu, $CH_2CF_3$, EtCl oder EtBr bedeutet, diese Eigenschaften auf.

Besonders gut geeignet sind natürlich jene Verbindungen, insbesondere Verbindungen der allgemeinen Formel (I), die bei einer Temperatur von maximal 150 °C auch flüssig sind. Verbindungen, in denen $R^1$, $R^2$ und/oder $R^3$ für Me oder Et steht, sind beispielsweise bei einer Temperatur von maximal 150 °C flüssig und bei dieser Maximaltemperatur und Normaldruck oder vermindertem Druck in die Gasphase überführbar.

Der Druck in der Gasphase kann mehr oder weniger hoch sein und richtet sich auch nach dem

angewendeten Zersetzungsverfahren. Man kann beispielsweise bei einem Druck arbeiten, der dem Dampfdruck der verwendeten Ausgangsverbindung bei der Arbeitstemperatur entspricht. Der Gesamtdruck kann aber auch höher sein, bis hin zum Normaldruck. Weiterhin kann man aber auch bei einem Druck arbeiten, der geringer ist als der Dampfdruck der verwendeten Ausgangsverbindung.

Die Zersetzung der Ausgangsverbindung in der Gasphase kann man beispielsweise nach Art eines CVD (Chemical-Vapour-Deposition)-Verfahren durchführen, ohne daß zusätzlich ein Plasma angewendet wird. Der Druck kann hier zwischen Normaldruck und etwa $10^{-3}$ Torr betragen. Zweckmäßig arbeitet man bei vermindertem Druck, beispielsweise bei $10^{-2}$ bis 50 Torr, vorzugsweise bei 0,1 bis 30 Torr.

Die prinzipielle Vorgehensweise zur Beschichtung von Substraten unter Anwendung eines solchen CVD-Verfahrens sowie geeigneter Apparaturen dafür sind beispielsweise aus der EP-A 297 348 bekannt.

Die Zersetzung aus der Gasphase wird zweckmäßig in einer druckfesten, evakuierbaren Vorrichtung durchgeführt. In diese Vorrichtung wird das zu beschichtende Substrat eingebracht. Bei vermindertem Druck wird dann eine Atmospäre erzeugt, die die Ausgangsverbindung enthält. Neben der gasförmig vorliegenden Ausgangsverbindung können, wie später noch erläutert wird, gewünschtenfalls weitere Gase im Gasraum der Vorrichtung vorhanden sein.

In einer Variante wird die Ausgangsverbindung zusammen mit dem zu beschichtenden Substrat in die Vorrichtung eingebracht.

In einer alternativen, bevorzugten Variante wird zunächst nur das Substrat in die druckfeste Vorrichtung eingebracht und die bereits gasförmig vorliegende Ausgangsverbindung über eine besondere Leitung kontinuierlich oder diskontinuierlich in die Vorrichtung eingebracht. Weitere Gase, sofern erwünscht, können als Trägergas für die Ausgangsverbindung dienen oder aber auch getrennt davon in die Vorrichtung eingeleitet werden.

Die Zersetzung erfolgt nach bekannten Methoden thermisch, plasmainduziert und/oder photolytisch.

Die thermische Zersetzung ohne Anwendung eines Plasmas aus der Gasphase führt man üblicherweise so durch, daß die Wände der Vorrichtung kalt gehalten werden und das Substrat auf eine Temperatur erhitzt wird, bei welcher sich die gewünschte B und N enthaltende Schicht auf dem Substrat abscheidet. Durch einfache orientierende Versuche kann die notwendige Mindesttemperatur für die jeweils eingesetzte Verbindung leicht bestimmt werden. Üblicherweise liegt die Temperatur, auf welche das Substrat erhitzt wird, oberhalb von etwa 300 °C.

Die Beheizung der Substrate kann in üblicher Weise erfolgen, beispielsweise durch Widerstandsheizung, Induktionsheizung, elektrische Heizeinrichtungen wie Heizwendeln oder ähnliches. Man kann auch einen erhitzten Draht (Filament) in der Apparatur anbringen. Dieses Filament aktiviert thermisch die Gasphase und kann auch zur Substratheizung benutzt werden. Diese Technik ist als "Hot Filament CVD (HFCVD)" bekannt. Die Aufheizung der Substrate kann auch durch Strahlungsenergie induziert werden. Hierfür eignet sich insbesondere Laserstrahlungsenergie. Beispielsweise kann man Laser verwenden, die im Bereich des sichtbaren Lichts im UV-Bereich oder im IR-Bereich arbeiten. Laser besitzen den Vorteil, daß man sie mehr oder weniger fokussieren kann. Auf diese Weise kann man gezielt bestimmte, begrenzte Bereiche oder Punkte des Substrats erhitzen.

Da das thermische CVD-Verfahren üblicherweise bei Unterdruck durchgeführt wird, ist es für den Fachmann selbstverständlich, druckfeste Apparaturen vorzusehen, wie sie in der Vakuumtechnik verwendet werden. Die Apparaturen weisen zweckmäßigerweise beheizbare Gasleitungen für die Ausgangsverbindung und/oder das weitere Gas auf. Weiterhin enthalten sie absperrbare Öffnungen für den Gasein- und -auslaß auf, gegebenenfalls Öffnungen zur Zuführung weiterer Gase, Temperaturmeßeinrichtungen, gewünschtenfalls eine Öffnung für die Zuführung der Ausgangsverbindung, eine Einrichtung für die Aufheizung des Substrats, eine zur Erzeugung des gewünschten Unterdruckes geeignete Pumpe etc. Für den Fall der Durchführung eines durch Strahlungsenergie induzierten CVD-Verfahrens muß natürlich auch noch eine Strahlungsquelle vorhanden sein.

Will man die Zersetzung photoinduziert durchführen, verwendet man eine entsprechende Apparatur mit einer geeigneten Strahlungsenergiequelle, beispielsweise einen Excimerenlaser.

Die Abscheidung einer B und N enthaltenden Schicht wird besonders bevorzugt plasmainduziert durchgeführt. Diese plasmainduzierte Zersetzung kann man ohne thermische Unterstützung durchführen. Gewünschtenfalls kann man das Substrat aber auch noch zusätzlich aufheizen.

Im Prinzip kann das Plasma nach verschiedensten bekannten Methoden erzeugt werden.

Beispielsweise kann man die Zersetzung mittels thermischer Plasmen bewirken. Hierzu zählen beispielsweise das Lichtbogenplasma und der Plasmajet. Der Druck in der verwendeten Apparatur liegt bei thermischen Plasmen üblicherweise zwischen Normaldruck und etwa 10 Torr.

Besonders gut geeignet sind Plasmaverfahren, die bei Niederdruck durchgeführt werden. Geeignet ist beispielsweise ein Gleichstromplasma (DC-Plasma), das auch nach Art eines gepulsten DC-Plasmas

durchgeführt werden kann. Der Druck in der Apparatur liegt hier zwischen 0,01 und 100 Torr, zweckmäßig zwischen etwa 0,05 und 1,0 Torr.

Besonders bevorzugt führt man die Zersetzung mit einem Wechselstromplasma (AC-Plasma) durch. Hier kann man kapazitativ oder induktiv eingekoppelte Niederfrequenzplasmen (Frequenzbereich: 30 bis 300 KHz), Mittelfrequenzplasmen (Frequenzbereich: 300 bis 3000 KHz) und Hochfrequenzplasmen (Frequenzbereich: 3 bis 30 MHz) unterscheiden. Man kann auch im Mikrowellenbereich (Frequenzbereich: 30 MHz bis zu einigen GHz) arbeiten. Ein Wechselstromplasma mit ganz besonders hoher Frequenz ist das Mikrowellenplasma, welches gewöhnlich bei 2,45 GHz arbeitet. Der Druck bei derartigen Wechselstromplasmen liegt üblicherweise zwischen 10 Torr und $10^{-2}$ Torr, bei bestimmten Plasmen (siehe unten) auch noch niedriger.

Wie dem Fachmann geläufig ist, weisen Apparaturen zur Plasmazersetzung häufig noch Einrichtungen zur Erzeugung eines Magnetfeldes auf. Dieses Magnetfeld hat gewöhnlich den Zweck, das Plasma zu verstärken. Der Ionisationsgrad wird dabei erhöht.

Ein besonderes, magnetfeldunterstütztes Plasmaverfahren ist das Electroncyclotronresonanzplasma (ECR-Plasma). Hier hat das Magnetfeld die Aufgabe, die im Plasma erzeugten Elektronen auf Kreisbahnen um die Magnetfeldlinien zu zwingen. Bei einer Magnetfeldstärke von 875 Gauss entspricht die Kreisfrequenz der Elektronen genau der Kreisfrequenz der eingestrahlten Mikrowellen (2,45 GHz). Dies führt zum Resonanzphänomen und somit zu einer optimalen Einkopplung der Mikrowellenleistung in das Plasma. Der Ionisationsgrad in einem ECR-Plasma liegt so um den Faktor 10 bis 100 höher als bei einer Glimmentladung.

Bei einem solchen ECR-Plasmaverfahren beträgt der Druck im Reaktor vorteilhaft zwischen $10^{-1}$ mbar bis $10^{-5}$ mbar.

Bevorzugt bewirkt man im erfindungsgemäßen Verfahren die Zersetzung durch ein Hochfrequenzplasma, beispielsweise Mikrowellenplasma, oder durch ein ECR-Plasma. Ein Hochfrequenzplasmaverfahren bietet den zusätzlichen Vorteil, daß man gleichzeitig nach Art eines Sputterverfahrens auch Metall in die Schichten inkorporieren kann. Man erhält dann Metall und B und N enthaltende Schichten.

Eine andere Möglichkeit, Metall und B und N enthaltende Schichten abzuscheiden, besteht darin, zusätzlich zu der Borazol-Ausgangsverbindung der allgemeinen Formel (I), (II) bzw. (III) eine unter den gleichen Bedingungen zersetzbare Metallverbindung einzusetzen. Dies ist sowohl bei thermischer Zersetzung als auch bei beliebigen plasmainduzierten Verfahren möglich und wird später noch beschrieben.

Die besonders bevorzugten Ausführungsformen der vorliegenden Erfindung, nämlich die Zersetzung durch ein Hochfrequenzplasma bzw. durch ein ECR-Plasma, werden im folgenden weiter erläutert.

Apparaturen, die bei der Zersetzung mit einem Hochfrequenzplasma verwendet werden können, sind dem Fachmann bekannt. Sie sind evakuierbar und weisen mindestens zwei Elektroden auf, über die ein hochfrequentes Feld erzeugt werden kann. Aus Zweckmäßigkeitsgründen sind die Elektroden vertikal angeordnet und werden im folgenden als "obere Elektrode" bzw. "untere Elektrode" bezeichnet. Die Elektroden können wahlweise als Anode bzw. Kathode geschaltet sein. Die Leistung des Hochfrequenzfeldes ist variabel und beträgt beispielsweise 50 bis 1500 Watt. Durch Anlegen einer Gleichspannung an die Elektroden, im folgenden als "Vorspannung", DC-Bias oder kurz "Bias" bezeichnet, ermöglicht die Beschleunigung von Plasmateilchen auf das zu beschichtende Substrat. Belegt man die Kathode mit einem Metall, so werden aus diesem Metall Atome durch Sputtern in die sich abscheidende Schicht auf dem Substrat mit eingebaut.

ECR-Plasmaverfahren werden in Apparaturen durchgeführt die ebenfalls vakuumfest sein müssen. Diese Apparaturen weisen einen Sender zur Abstrahlung eines Hochfrequenz- oder Höchstfrequenzfeldes auf, beispielsweise einen Mikrowellensender. Senkrecht zur Abstrahlungsrichtung, um die Plasmakammer herumgelegt, sind Magnetspulen angeordnet. Diese erzeugen ein Magnetfeld parallel zur Abstrahlungsrichtung, welches die im Plasma vorliegenden Elektronen unter dem gleichzeitigen Einfluß der MW-Strahlung auf Kreisbahnen zwingt. Die Leistung des Mikrowellensenders ist sehr variabel. Je nach Gerät kann die Leistung weniger als 50 Watt bis hin zu 800 Watt und mehr betragen. Durch Anlegen einer Gleichspannung oder HF-Wechselspannung zwischen Substratträger und Rezipienten kann die Geschwindigkeit auftreffender Plasmateilchen auf das Substrat erhöht werden.

Gemäß einer Variante des erfindungsgemäßen Verfahrens arbeitet man in einer Gasatmosphäre, die nur aus den verdampften Molekülen der verwendeten Ausgangsverbindung der allgemeinen Formel (I), (II) oder (III) besteht. In diesem Fall lassen sich Schichten abscheiden, die B, N und weiterhin Kohlenstoff und Wasserstoff enthalten. Schichten dieser Art sind beispielsweise Schutzschichten gegen äußere Einflüsse.

Gemäß einer anderen, bevorzugten Variante zersetzt man in Gegenwart weiterer Gase.

Dies können beispielsweise Gase sein, die die abzuscheidende Schicht in ihrer chemischen Zusammensetzung oder in ihrem physikalischen Aufbau beeinflussen.

Als weiteres Gas wählt man vorzugsweise ein oder mehrere Gase aus der Gruppe Edelgase, insbesondere Argon, Wasserstoff und N-haltige Gase, insbesondere $N_2$ oder $NH_3$ aus.

Zersetzt man beispielsweise in Gegenwart von Gasen, die als chemisch inert anzusehen sind, beispielsweise in Anwesenheit von Edelgasen wie Argon oder Inertgasen wie Stickstoff, so kann die Härte und Haftfestigkeit der Schichten modifiziert werden.

Man kann auch in Anwesenheit reaktiver Gase, wie organischen Aminen oder vorzugsweise Ammoniak und/oder Wasserstoff enthaltender Atmosphäre arbeiten. In diesem Fall erhält man B und N enthaltende Schichten, die sehr kohlenstoffarm und überraschenderweise auch wasserstoffarm sind.

Man kann weiterhin in Gegenwart von Metallverbindungen, insbesondere organischen Metallverbindungen arbeiten. Hier werden Schichten abgeschieden, die Metall, B, N und gegebenenfalls Kohlenstoff und Wasserstoff enthalten. Zweckmäßig wählt man Metallverbindungen aus, die unter den gleichen Bedingungen wie die Ausgangsverbindung der allgemeinen Formel (I), (II) bzw. (III) verdampfen und sich unter diesen Bedingungen auch zersetzen. Man verwendet insbesondere flüchtige metallorganische Verbindungen von Refraktärmetallen, insbesondere von Niob, Tantal, Vanadium, Wolfram, Molybdän, Titan, Zirkonium, Hafnium sowie der Eisenmetalle Eisen, Kobalt und Nickel. Beispielsweise kann man entsprechende Metallhalogenide, Metallalkyle, Metallalkoholate, Carbonyle verwenden.

Weiterhin kann man die Ausgangsverbindung der allgemeinen Formeln (I), (II) bzw. (III) auch als Reaktivgas bei der Plasmadiffusionstechnik einsetzen. Bei dieser dem Fachmann bekannten Technik werden die zu beschichtenden Werkstücke als Kathode geschaltet und im anormalen Glimmbereich gearbeitet. Man erhält dann Schichten auf dem Werkstück, welche Metall, B, N und gegebenenfalls C enthalten.

Weiterhin kann man auch in Gegenwart halogenhaltiger Gase, insbesondere in Gegenwart halogenhaltiger Ätzgase, zersetzen. Hier kann man im Prinzip beliebige, aus der Dünnschichttechnik bekannte Gase verwenden, insbesondere Stickstofftrifluorid, Chlorfluorkohlen(wasser)stoffverbindungen, perfluorierte Alkylverbindungen wie insbesondere $CF_4$ oder $CFCl_3$. Führt man die Plasmazersetzung in Anwesenheit solcher Ätzgase durch, so können bestimmte Phasen der abgeschiedenen Schicht, beispielsweise die hexagonale Phase oder amorphe Phasen weggeätzt werden. Auf diese Weise ist es möglich, die Schichteigenschaften in-situ zu modifizieren.

Es wurde schon erwähnt, daß man im Hochfrequenzplasma auch durch Belegen der Kathode mit Metall durch Sputtern eine Metall, B und N sowie gegebenenfalls Kohlenstoff und Wasserstoff enthaltende Schicht abscheiden kann. Als Metalle sieht man auch hier insbesondere Refraktärmetalle, wie oben ausgeführt, vor. Auch bei dieser Variante kann man in Anwesenheit von weiteren Gasen arbeiten. Die Wirkung auf die abgeschiedene Schicht ist wie vorstehend beschrieben.

Die Dicke der abgeschiedenen Schicht richtet sich nach dem Anwendungszweck und kann sehr variabel sein. Man kann Schichten mit einer Dicke von bis zu 40 Mikrometern, beispielsweise zwischen $10^{-2}$ und 20 Mikrometern, erzielen. Die erfindungsgemäßen Schichten zeichnen sich durch große Härte und entsprechende Schutzwirkung aus. Insbesondere gelingt es, transparente Schichten zu erzeugen.

Nach dem erfindungsgemäßen Verfahren lassen sich verschiedenste Substrate beschichten.

Beispielsweise kann man metallische Substrate, z.B. Stähle, Refraktärmetalle, Aluminium und Aluminiumlegierungen, Edelmetalle wie Gold, Münzmetalle, Platin etc. beschichten. Weiterhin kann man keramische Substrate, beispielsweise oxidische Substrate auf Basis von Aluminiumoxid oder Zirkoniumoxid, sowie auch nichtoxidische Substrate, z.B. Carbide oder Nitride, erfindungsgemäß beschichten. Gleichermaßen kann man auch Substrate aus Glas, beispielsweise aus Siliciumdioxid oder silikatische Gläser, erfindungsgemäß beschichten. Auch polymere Substrate wie Polymethylmethacrylat, Polypropylen, Polyethylen, Polystyrol, Polyphenylensulfid, PVC, Polyamide, Polyimide, Epoxid-Harze und andere können beschichtet werden, ebenso Halbleitermaterialien wie Silicium oder Galliumarsenid.

Weitere Substrate können beispielsweise Fasern sein wie Kohlenstoffasern.

Die nach dem erfindungsgemäßen Verfahren abgeschiedenen, B und N enthaltenden Schichten sind Hartschichten und vermitteln den Substraten, auf denen sie abgeschieden sind, insbesondere Schutz gegen Verschleiß, Korrosion und Oxidation. Die solchermaßen versehenen Substrate können für verschiedenste Zwecke eingesetzt werden. Gegen Verschleiß geschützte, gehärtete Substrate können beispielsweise im Maschinenbau als Druckmaschinenteile (u.a. Walzen), als Turbinenschaufeln, als Extruderschnecken oder als Spritzgußwerkzeug eingesetzt werden. Gleichermaßen nach dem erfindungsgemäßen Verfahren härten und gegen Verschleiß schützen lassen sich Schneidwerkzeuge, Preßwerkzeuge oder mechanische Antriebskomponenten wie Zahnräder, Lager oder Wellen, ebenso Armaturen und Düsen.

In der Luft- und Raumfahrt kann man beispielsweise Bremsenkomponenten, Fahrwerkskomponenten oder Triebwerksteile nach dem erfindungsgemäßen Verfahren härten und gegen Verschleiß schützen.

Durch ein plasmaunterstütztes erfindungsgemäßes Abscheideverfahren kann man die Toruswand von

Fusionsplasmareaktoren mit einer B, C, N und H enthaltenden Hartschicht belegen.

Im Kraftfahrzeuggewerbe kann man insbesondere mechanische Antriebskomponenten wie Zahnräder, Lager, Wellen (Nockenwelle), etc. und Teile im heißen Motorbereich wie Ventile, Kolbenringe oder Zylinderwände sowie Pleuel nach dem erfindungsgemäßen Verfahren beschichten und härten sowie gegen Verschleiß schützen.

In der Elektrotechnik kann man beispielsweise Elektroden erfindungsgemäß behandeln.

In der Feinmechanik und Optik kann man beispielsweise feinmechanische Antriebselemente wie Zahnräder, Lager oder Wellen erfindungsgemäß beschichten, härten und gegen Verschleiß schützen.

Ganz besonders vorteilhaft sind die transparenten nach dem erfindungsgemäßen Verfahren erhältlichen Schichten. Mit ihnen kann man optische Komponenten beschichten, ohne daß die Empfindlichkeit gegenüber bestimmte elektromagnetische Strahlung wie Licht beeinflußt wird. So kann man beispielsweise Fotozellen mit einer Schutzschicht oder einer Entspiegelungsschicht versehen oder optisch vergüten, ohne daß die optischen Eigenschaften der Fotozellen beeinflußt wird. Ein weiteres Anwendungsgebiet ist die Abscheidung von erfindungsgemäßen Schichten als Schutzschicht auf Spiegel, beispielsweise auf Spiegel aus Gold, wie sie in Laservorrichtungen verwendet werden.

Erfindungsgemäß abgeschiedene Schichten, die außerdem auch noch Metall enthalten, sind ebenfalls Hartstoffschichten und schützen gegen Korrosion und Verschleiß. Weiterhin sind sie wertvoll aufgrund ihrer spiegelnden Eigenschaften.

Die folgenden Beispiele sollen das erfindungsgemäße Verfahren weiter erläutern, ohne es in seinem Umfang einzuschränken.

"Kp." bedeutet "Kochpunkt (Siedepunkt)", "Smp." bedeutet "Schmelzpunkt", "Subl.punkt" bedeutet "Sublimationspunkt", "gem." bedeutet "gemessen".

Beispiel 1

Herstellung von N,N',N''-Trimethylborazol

In einem 1 l-Dreihalskolben mit Magnetrührer, Gaseinlaß, Tropftrichter und Rückflußkühler mit angeschlossener, auf - 196 °C gekühlter Falle wurden unter Inertgas 41,1 g (1,1 mol) Natriumborhydrid und 67,5 g (1,0 mol) Methylammoniumchlorid vorgelegt. Durch den Tropftrichter wurden binnen 10 Minuten etwa 500 ml Triethylenglycoldimethylether zugetropft. Die Reaktion setzte unter starker Wärme- und Wasserstoffentwicklung ein. Nach 30 Minuten wurde dann die Reaktionsmischung mit einem Heizpilz erhitzt und 6 Stunden lang am Rückfluß gekocht. Es wurde starkes Schäumen beobachtet. Anschließend wurden zunächst diejenigen Bestandteile abdestilliert, die bei bis zu 80 °C und zwei Torr siedeten. Diese Bestandteile wurden über eine Vigreux-Kolonne fraktioniert. Das Borazolderivat siedete bei 200 bis 250 Torr und einer Siedetemperatur von 95 bis 115 °C.

Ausbeute: 19,9 g (48,7 % der Theorie)

$^{n}D^{20}$ gem.: 1,4375

$^{n}D^{20}$ Lit.: 1,4375

Beispiel 2

Herstellung von N,N',N''-Trialkylborazol mit Alkyl = n-Propyl, i-Propyl und t-Butyl

Unter Inertgas wurden in einem 4 l-Dreihalskolben mit mechanischem Rührer (KPG-Rührer), Rückflußkühler und Tropftrichter 104 g (2,75 mol) Natriumborhydrid in 1 l getrocknetem Tetrahydrofuran und 3 mol primäres Alkylamin vorgelegt. In diese Mischung wurden dann binnen 2 bis 3 Stunden unter starkem Rühren 390 g (2,75 mol) Bortrifluorid-Etherat derart zugetropft, daß die Gasentwicklung nicht zu heftig wurde. Anschließend wurde noch 2,5 Stunden unter Rückfluß gekocht und dann vom ausgefallenen Natriumtetrafluoroborat über eine Umkehrfritte abfiltriert. Danach wurden leicht flüchtige Bestandteile, insbesondere Ether, Tetrahydrofuran und überschüssiges Amin abdestilliert.

Die Propylborazolverbindungen wurden fraktionierend destilliert, die t-Butylborazolverbindung wurde sublimiert.

2.1. Herstellung von N,N',N''-tri-n-propylborazol

| | |
|---|---|
| Kp | 100 °C/14 Torr |
| $^{n}D^{20}$ Lit. | 1,4484 |
| $^{n}D^{20}$ gem. | 1,4475 |
| Ausbeute | 160 g (86 % d. Theorie) |
| Bemerkung | Das Produkt kristallisiert beim Stehenlassen teilweise aus. |

2.2. Herstellung von N,N',N''-tri-i-propylborazol

| | |
|---|---|
| $^{Kp}$Lit. | 44 °C/ 1 Torr |
| $^{Kp}$gem. | 75 °C/10 Torr |
| $^{n}D^{20}$ Lit. | 1,4434 |
| $^{n}D^{20}$ gem. | 1,4440 |
| Ausbeute | 81,65 g (44 % d. Theorie) |
| Bemerkung | Das Produkt kristallisiert während der Destillation und beim Stehenlassen teilweise aus. |

2.3. Herstellung von N,N',N''-tri-tert-butylborazol

| | |
|---|---|
| Subl.punkt | 60 - 70 °C/$10^{-3}$ Torr |
| $^{Smp}$Lit. | 89 - 94 °C |
| $^{Smp}$gem. | 90 - 92 °C |

Es wurden 71 g Rohprodukt sublimiert: Ausbeute (Sublimat): 53,2 g (75 % d. Theorie).

$^{1}$H-NMR-Daten (in $CD_2Cl_2$) von Borazolen

| | | |
|---|---|---|
| $(H\text{-}B\text{-}N\text{-}CH_3)_3$ | $N\text{-}CH_3$ | 3,04 ppm (S; 3H) |
| $(H\text{-}B\text{-}N\text{-}CH_2\text{-}CH_2\text{-}CH_3)_3$ | $N\text{-}CH_2$<br>$C\text{-}CH_2\text{-}C$<br>$-CH_3$ | 3,25 ppm (T; 2H)<br>1,51 ppm (M; 2H)<br>0,85 ppm (T; 3H) |
| $(H\text{-}B\text{-}N\text{-}CH(CH_3)_2)_3$ | C-H<br>$-CH_3$ | 3,67 ppm (M; 1H)<br>1,23 ppm (D; 6H) |
| $(H\text{-}B\text{-}N\text{-}C(CH_3)_3)_3$ | $-CH_3$ | 1,37 ppm (S; 9H) |

Beispiel 3:

Abscheidung einer BN-Schicht im ECR-Plasma

In einer ECR-Plasmakammer wurden 0,8 sccm (sccm = standard cubic centimeter) N-Trimethylborazol und 5 sccm Ammoniak geleitet. Bei einem Arbeitsdruck von 0,060 Pa wurde ein ECR-Plasma gezündet. Unterhalb der Plasmakammer befand sich im Rezipienten in einem Abstand von 5 cm, bezogen auf die Unterkante der Plasmakammer, ein auf 600 °C beheizter Substrattisch, beladen mit einem 2''Si-Wafer. Die eingekoppelte Mikrowellenleistung betrug 600 Watt. An das Substrat wurde ein DC-Bias von -75 V angelegt. Mit einer Wachstumsrate von 1,2 µm/h scheidet sich unter diesen Bedingungen ein kohlenstofffreier Film mit folgender Zusammensetzung ab: B = 49,6 Atom-%, N = 46,4 Atom-% ab. Die Elementarzusammensetzung wurde mittels EPMA (electron probe micro analysis) ermittelt.

Beispiel 4:

Abscheidung einer BCNH-Schicht im ECR-Plasma

In einer ECR-Plasmakammer wurden 3 sccm Argon eingeleitet und ein ECR-Plasma gezündet. In den Rezipienten wurden 1,0 sccm N-Trimethylborazol geleitet und in den Plasmastrahl geführt. Der Arbeitsdruck lag bei 0,036 Pa, die eingekoppelte Mikrowellenleistung betrug 320 Watt. Der nicht geheizte Substrattisch befand sich 10 cm von der Unterkante der Plasmakammer entfernt. Die Aufheizung des 2"Si-Wafer durch das Plasma betrug ca. 150 °C. Mit einer Abscheidungsrate von 0,7 µm/h wurde ein transparenter Film mit der Elementarzusammensetzung B: 38,4 Atom-%, C: 29,9 Atom-% und N: 30,7 Atom-% (ermittelt durch EPMA) erhalten. Die Anwesenheit von geringen Mengen an Wasserstoff im Film konnte durch IR-spektroskopische Untersuchungen anhand der NH-, CH- und BH-Schwingungen gezeigt werden.

Beispiel 5:

Abscheidung einer BCNH-Schicht im Hochfrequenz (HF)-Plasma

Zur Filmabscheidung im HF-Plasma wurde mit einem Parallelplattenreaktor gearbeitet, in dem wahlweise die obere oder untere Elektrode als HF-Elektrode ("Kathode") fungieren kann. In diesen Reaktor wurden 18 sccm Argon und 1,5 sccm N-Trimethylborazol eingeleitet. Die Substrate (Silizium, Edelstahl, Glas) wurden auf die untere nicht beheizte Elektrode gelegt. Bei Schaltung der substrattragenden Elektrode als HF-Elektrode wurde bei einem Druck von 1,2 Pa ein HF-Plasma gezündet. Die eingespeiste HF-Leistung betrug 200 Watt, wodurch sich an der Substratelektrode ein Gleichstrom-Bias (Selfbias) von 650 V einstellt. Mit einer Abscheidungsrate von 0,43 µm/h wurde ein Film mit folgender Elementarzusammensetzung erhalten: B: 37,3 Atom-%, C: 35,75 Atom-% und N: 24,49 Atom-%. Das IR-Spektrum dieses Films zeigte schwache Absorptionen im Bereich der NH-, CH- und BH-Schwingungen.

Beispiel 6:

Abscheidung einer TiBCN-Schicht im HF-Plasma

Die Abscheidung einer TiBCN-Schicht wurde in einer Sputter-CVD-Anlage durchgeführt. Durch HF-Sputtern wurde von einem Titantarget Titan abgestäubt und gleichzeitig N-Trimethylborazol in den Reaktor geleitet.
Sputter-Bedingungen: 40 sccm Argon, Druck 2,0 Pa, HF-Leistung: 1,0 kW; DC-Selfbias 1,9 kV.
In dieses Sputter-Plasma wurde nun N-Trimethylborazol zugefügt, bis der Arbeitsdruck auf 2,05 Pa anstieg. Durch Reaktion von Titan mit im Plasma angeregten N-Trimethylborazol wurde auf der nicht geheizten Substratelektrode eine TiBCN-Schicht abgeschieden. Als Substrate dienten Silizium, Edelstahl und Glas. Bei einer Wachstumsrate von 0,9 µm/h schied sich eine dunkelbraune reflektierende Schicht ab. Die Schicht hatte folgende Elementarzusammensetzung (bestimmt mittels EPMA): Ti: 26,9 Atom-%, B: 23,5 Atom-%, C: 35,9 Atom-% und N: 14,6 Atom-%. Das Röntgendiffraktogramm des Films belegte die Existenz kubischer Carbid- und Nitridphasen.

Beispiele 7 - 8:

Abscheidung von BN-Schichten durch Zersetzung von N,N',N"-Trimethylborazol durch ein thermisches CVD-Verfahren

7. Abscheidung auf einem Silicium-Wafer
7.1. Allgemeines:
Die Abscheidung wurde nach dem "thermisch aktivierten Heißdraht-CVD-Verfahren" (hot filament-Prozess) durchgeführt. Dabei wird das Substrat durch den, in die Nähe des Substrats positionierten Draht erhitzt; die Temperatureinstellung des Substrats erfolgt über die Stromstärke, mit welcher der Draht erhitzt wird.
In den Reaktor wurden 800 sccm (Standard-$cm^3$) $H_2$ und 5 bis 30 sccm N,N',N"-Trimethylborazol eingeleitet. Der Gesamtdruck im Reaktor lag zwischen 23 und 25 mbar. Das Substrat wurde auf eine Temperatur im Bereich von 650 bis 1000 °C erhitzt, die Drahttemperatur (Filament-Temperatur) betrug 980 bis 2200 °C. Das N,N',N"-Trimethylborazol (Precursor) wurde auf 60 °C erwärmt.

Die jeweiligen Versuchsbedingungen und Abscheideergebnisse von 4 Versuchen mit variierenden Substrattemperaturen und Precursordruck sind im folgenden aufgelistet.

7.2.1.

| | |
|---|---|
| Substrat-Temperatur | 650 °C |
| Precursor-Druck | 0,3 mbar |
| Wasserstoff-Druck | 22,8 mbar |
| Abscheiderate der BN-Schicht | 0,02 Micrometer/Minute |

7.2.2.

| | |
|---|---|
| Substrat-Temperatur | 860 °C |
| Precursor-Druck | 0,3 mbar |
| Wasserstoff-Druck | 23,01 mbar |
| Abscheiderate der BN-Schicht | 0,3 Micrometer/Minute |

7.2.3.

| | |
|---|---|
| Substrat-Temperatur | 860 °C |
| Precursor-Druck | 1,0 mbar |
| Wasserstoff-Druck | 22,8 mbar |
| Abscheiderate der BN-Schicht | 0,3 Micrometer/Minute |

7.2.4.

| | |
|---|---|
| Substrat-Temperatur | 1000 °C |
| Precursor-Druck | 0,2 mbar |
| Wasserstoff-Druck | 23,14 mbar |
| Abscheiderate der BN-Schicht | 0,08 Micrometer/Minute |

Die Analyse der Schichten durch Infrarot(IR)-Spektroskopie ergab, daß Schichten aus hexagonalem BN abgeschieden worden waren. Die Beispiele belegen, daß die Abscheidungsrate und Dicke der BN-Schichten vorteilhafterweise eingeregelt werden kann.

Beispiel 8:

Thermische CVD-Abscheidung von BN-Schichten auf anderen Substraten als Silicium

| | |
|---|---|
| 8.1. - 8.4. | Abscheidung auf Molybdän-Wafern |
| 8.5. - 8.8. | Abscheidung auf Wolfram-Wafern |
| 8.9. - 8.12. | Abscheidung auf Glasfasern |

Die Versuche 7.2.1. bis 7.2.4. wurden wiederholt. Anstelle eines Silicium-Wafers wurden Molybdän-Wafer (Beispiele 8.1. - 8.4.), Wolfram-Wafer (Beispiele 8.5. - 8.8.) und Glasfasern (8.9. - 8.12.) eingesetzt. Die erhaltenen Schichten waren vergleichbar mit jenen Schichten, die bei den entsprechenden Beispielen 7.2.1. bis 7.2.4. erhalten worden waren.

Vergleichbare Schichten wurden ebenfalls erhalten beim Ersatz des Wasserstoffgases durch $N_2$, Ar oder $NH_3$.

**Patentansprüche**

**1.** Verfahren zur Abscheidung einer Bor (B) und Stickstoff (N) enthaltenden Schicht auf einem Substrat, dadurch gekennzeichnet, daß man durch Zersetzung einer Verbindung der allgemeinen Formel (I), (II) oder (III)

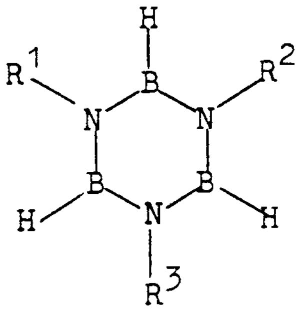

(I)

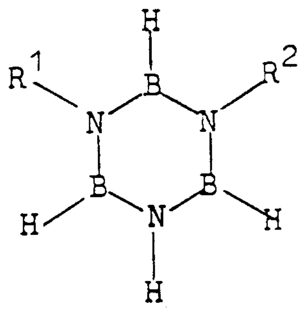

(II)

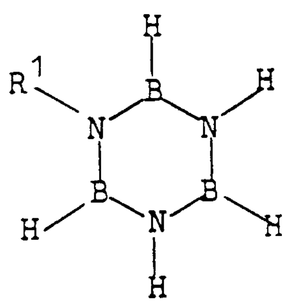

(III)

worin $R^1$, $R^2$ und $R^3$ gleich oder verschieden sein können und bedeuten:

lineares oder verzweigtes Alkyl mit 1 bis 12 C-Atomen;

lineares oder verzweigtes Alkyl, substituiert durch ein oder mehrere Substituenten ausgewählt aus Halogen, Niedrigalkyloxy, Diniedrigalkylamin und dessen Adukt mit $BH_3$;

lineares oder verzweigtes Alkyl, substituiert durch ein oder mehrere Aryl-Reste, insbesondere Phenyl;

lineares oder verzweigtes Alkyl, substituiert durch ein oder mehrere Aryl-Reste, die ihrerseits durch ein oder mehrere Substituenten ausgewählt aus der Gruppe Halogen, Niedrigalkyl, halogeniertes Niedrigalkyl substituiert sind;

Cycloalkyl, Cycloalkenyl oder Cycloalkadienyl mit einem C4-C7-Kohlenstoffring;

Cycloalkyl, Cycloalkenyl oder Cycloalkadienyl mit einem C4-C7-Kohlenstoffring, substituiert durch Niedrigalkyl;

Aryl, insbesondere Phenyl, Toluyl, Aryl mit einem oder mehreren kondensierten Ringen, insbesondere Naphthyl;

Aryl, insbesondere Phenyl, substituiert durch einen oder mehrere Substituenten ausgewählt aus der Gruppe Halogen, Niedrigalkyl; durch Halogen substituiertes Niedrigalkyl; Niedrigalkoxy; Diniedrigalkylamin; Phenyl; Cycloalkyl mit C4-C7-Kohlenstoffring;

Alkenyl mit 2 bis 4 C-Atomen;

Triniedrigalkylsilyl;

Halogen, vorzugsweise Fluor;

eine B und N enthaltende Schicht abscheidet.

**2.** Verfahren nach Anspruch 1, dadurch gekennzeichnet, daß man eine Verbindung der allgemeinen Formel (I) verwendet.

**3.** Verfahren nach einem der vorhergehenden Ansprüche, dadurch gekennzeichnet, daß man eine Verbindung bevorzugt der allgemeinen Formel (I) verwendet, in welcher $R^1$, $R^2$ und/oder $R^3$ gleich oder verschieden sein können und lineares oder verzweigtes Alkyl mit 1 bis 12 C-Atomen, vorzugsweise lineares oder verzweigtes Alkyl mit 1 bis 5 C-Atomen, insbesondere Methyl, Ethyl, n-Propyl, i-Propyl, n-Butyl, i-Butyl oder t-Butyl bedeutet.

**4.** Verfahren nach einem der vorhergehenden Ansprüche, dadurch gekennzeichnet, daß man eine Verbindung der allgemeinen Formel (I) verwendet, in welcher $R^1$, $R^2$ und $R^3$ gleich sind.

**5.** Verfahren nach einem der vorhergehenden Ansprüche, dadurch gekennzeichnet, daß man eine Verbindung vorzugsweise der allgemeinen Formel (I) einsetzt, die bei einer Temperatur von maximal 150 °C und Normaldruck oder vermindertem Druck in die Gasphase überführbar ist.

**6.** Verfahren nach Anspruch 1, dadurch gekennzeichnet, daß man die Zersetzung thermisch oder mittels Strahlungsenergie, insbesondere Laserstrahlungsenergie, bewirkt.

**7.** Verfahren nach Anspruch 1, dadurch gekennzeichnet, daß man die Zersetzung plasmainduziert bewirkt.

**8.** Verfahren nach Anspruch 7, dadurch gekennzeichnet, daß man die Zersetzung durch ein Hochfrequenzplasma, Mikrowellenplasma oder ein Elektroncyclotronresonanzplasma bewirkt.

**9.** Verfahren nach einem der vorhergehenden Ansprüche, dadurch gekennzeichnet, daß man eine verdampfbare Verbindung der allgemeinen Formel (I), (II) oder (III) verwendet, diese Verbindung bei vermindertem Druck in die Gas- oder Dampfphase überführt und unter vermindertem Druck zersetzt.

**10.** Verfahren nach einem der vorhergehenden Ansprüche, dadurch gekennzeichnet, daß man in Gegenwart weiterer Gase zersetzt.

**11.** Verfahren nach einem der Ansprüche 1 bis 9, dadurch gekennzeichnet, daß man als weiteres Gas ein oder mehrere Gase aus der Gruppe Edelgase, vorzugsweise Argon, Wasserstoff, N-haltige Gase, vorzugsweise $N_2$ und/oder $NH_3$ auswählt.

**12.** Verfahren nach einem der vorhergehenden Ansprüche, dadurch gekennzeichnet, daß man zur Abscheidung von B, N und gegebenenfalls C sowie Metall enthaltenden Schichten neben einer Verbindung der allgemeinen Formel (I), (II) oder (III) eine unter den gleichen Bedingungen zersetzbare Metallverbindung zersetzt.

**13.** Verfahren nach einem der Ansprüche 1 bis 11, dadurch gekennzeichnet, daß man zur Abscheidung von B, N sowie Metall enthaltenden Schichten die Zersetzung einer Verbindung der allgemeinen Formel (I),

(II) oder (III) vorzugsweise plasmainduziert durchführt und die gleichzeitige Metallabscheidung nach dem Sputter-Verfahren vornimmt.

**14.** Verfahren nach einem der vorhergehenden Ansprüche, dadurch gekennzeichnet, daß man als Metalle Refraktärmetalle abscheidet.

**15.** Verfahren nach einem der vorhergehenden Ansprüche, dadurch gekennzeichnet, daß man als Substrate metallische oder keramische Substrate, Glas, Polymere oder Halbleiter einsetzt.

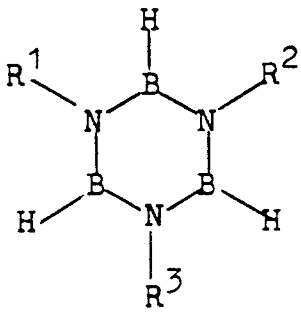

(I)

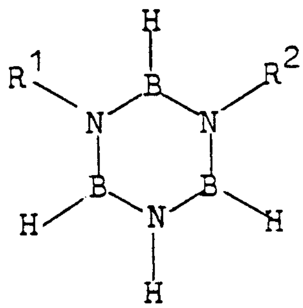

(II)

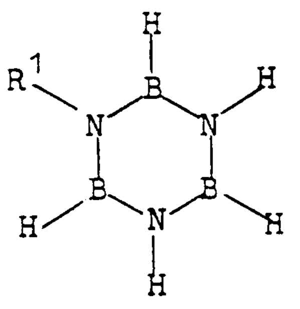

(III)